# EUROPEAN PATENT SPECIFICATION

(11) **EP 0 757 347 B1**
(45) Date of publication and mention of the grant of the patent: **12.09.2001**
(21) Application number: 96305730.2
(22) Date of filing: 02.08.1996
(51) Int. Cl.: G11B 20/14, H03M 5/14

(54) **Control signal generation apparatus for a digital information signal recording system**
Gerät zur Steuersignalerzeugung für ein System zur Aufzeichnung von digitalen Informationssignalen
Appareil de génération de signaux de commande pour un système d'enregistrement d'un signal numérique d'information

(30) Priority: 03.08.1995 KR 9523993
(43) Date of publication of application: 05.02.1997
(73) Proprietor: SAMSUNG ELECTRONICS CO., LTD., Suwon-City, Kyungki-do (KR)
(72) Inventor: Ko, Jung-wan, Suwon-city, Kyungki-do (KR); Chang, Yong-deok, Suwon-city, Kyungki-do (KR)
(74) Representative: Chugg, David John

(56) References cited:
- EP-A- 0 476 766
- EP-A- 0 593 173
- EP-A- 0 709 844
- EP-A- 0 709 845
- US-A- 5 142 421
- US-A- 5 432 651
- PATENT ABSTRACTS OF JAPAN vol. 018, no. 519 (P-1807), 29 September 1994 & JP 06 176495 A (MATSUSHITA ELECTRIC IND CO LTD), 24 June 1994,

## Description

The present invention relates to an apparatus for generating control signals used in a recording device for recording a digital information signal on a digital record medium, and more particularly, to an apparatus for generating control signals concerning selection of the channel word to be recorded on an information track of a digital record medium, in a recording device for recording channel words on information tracks in the magnetic record medium, in which (n+1)-bit information words each of which successive information word has an affixed one-bit digital word are converted into (n+1)-bit channel words in precoders.

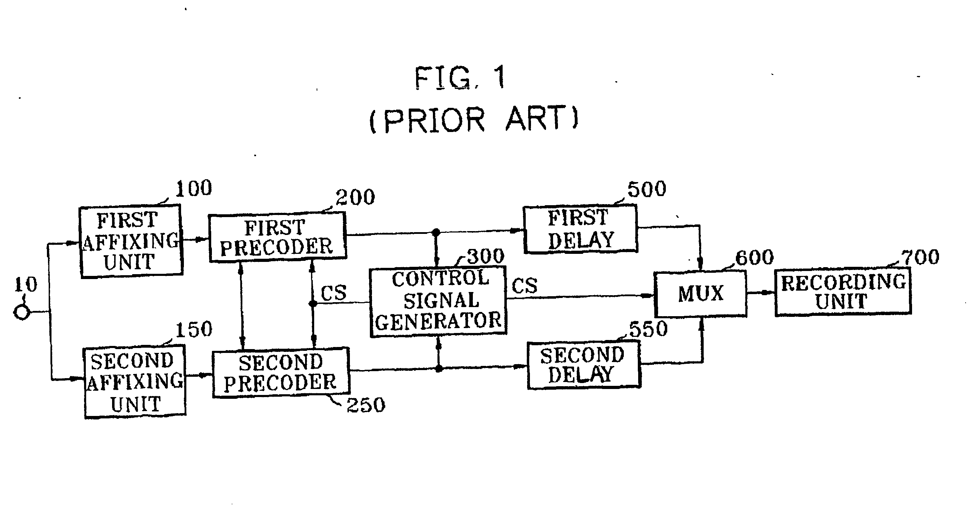

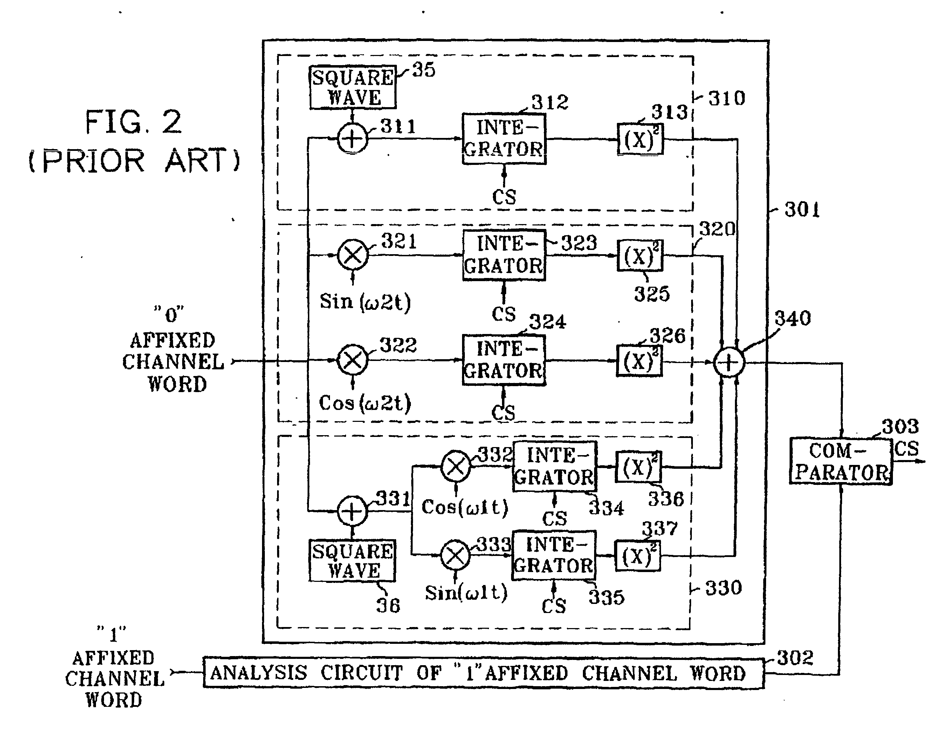

A general 8mm video tape recording system records a recording signal together with a pilot signal on each recording track of a record medium, in order to accurately control the recording tracks. However, a method for recording pilot signals having simply different frequencies together with recording signals is inefficient in terms of a utility efficiency of the record medium. This is because the pilot signals in neighbouring tracks should be sufficiently far from a pilot signal in a track to be reproduced, in order not to cause crosstalk with the pilot signal on the frequency spectrum. To solve the above problem, a high efficiency encoding technology is disclosed in US patent number 5 142 421 to Kahlman et al, issued on August 25 1992, entitled "Device for Recording a Digital Information Signal On A Record Carrier". This prior art will be described below with reference to Figures 1 and 2.

Figure 1 shows a device for recording a digital information signal on a record carrier, which is referred to in the above prior art. In Figure 1, a first affixing unit 100 affixes "0" to a successive n-bit information word input via an input end 10, and a second affixing unit 150 affixes "1" to the successive n-bit information word. First and second precoders 200 and 250 converts the (n+1)-bit information words into (n+1)-bit channel words, respectively. The output of the first precoder 200 is supplied to a control signal generator 300 and a first delay 500, and the output of the second precoder 250 is supplied to the control signal generator 300 and a second delay 550. The control signal generator 300 to be described later in detail referring to Figure 2 generates a control signal CS using the applied data. The control signal CS is supplied to the first and second precoders 200 and 250 and a multiplexer 600. The first and second delays 500 and 550 delay the input data until the control signal generator 300 generates a control signal corresponding to the input data. The multiplexer 600 selects one of the output signals from the first and second delays 500 and 550 according to the control signal CS and supplies the selected signal to a recording unit 700. The first and second precoders 200 and 250 operate to contain the identical contents in internal memories in response to the control signals CS. For example, when the output data of the first precoder 200 is transmitted to the recording unit 700, the contents contained in the first precoder 200 is supplied to the second precoder 250, with a result that the first and second precoders 200 and 250 contain the identical contents.

Figure 2 is a detailed block diagram of the control signal generator 300 of Figure 1. The control signal generator 300 of Figure 2 includes a spectrum analysis circuit 301 receiving the output signal of the first precoder 200 and a spectrum analysis circuit 302 receiving the output signal of the second precoder 250. Since the spectrum analysis circuits 301 and 302 have the same constitution, the structure of only a spectrum analysis circuit 301 is shown in detail in Figure 2. The spectrum analysis circuit 301 shown in detail in Figure 2 is substantially the same as those disclosed in Figure 17 of US patent number 5 142 421 except for an adder 311, an integrator 312 and a square wave generator 35. Since differences between spectrum analysis circuit 301 of Figure 2 and the Figure 17 circuit of the above prior art reference can be fully understood by one skilled in the art, the detailed description of the differences will be omitted. The spectrum analysis circuit 301 includes three spectrum detectors respectively having a peak detector 310 for detecting a peak component in which a particular frequency component is larger than a reference set value, a notch detector 320 for detecting a notch component capable of discriminating whether the particular frequency component is smaller than the reference set value, and a dip detector 330 for detecting a dip component assisting peak detection by attenuating a certain amount around the peak component. Peak detector, notch detector and dip detector 310, 320 and 330 detect the peak, notch and dip components from "0"-affixed channel word, respectively. An adder 340 sums output signals from detectors 310, 320 and 330. A spectrum analysis circuit 302 performs the same operation as that of the spectrum analysis circuit 301 with respect to "1"-affixed channel word. A comparator 303 compares the output signals of spectrum analysis circuits 301 and 302, to thereby generate the control signal CS. Since the above adder 340 receives the five signals and sums all these signals, the circuit construction becomes complicated. Also, an accurate result cannot be obtained unless relative gains are the same when each spectrum is estimated. Further, since the complicated circuit lengthens a processing time, a digital circuit having a negative feedback loop requires a high-speed operational device to complete the negative feedback loop with a certain time.

With a view to solving or reducing the above problem, it is an aim of embodiments of the present invention to provide a control signal generation apparatus in a digital information signal recording system in which a circuit for analyzing a spectrum is simplified and the number of the maximum allowable bits of an integrator included in each spectrum detector is reduced, to thereby improve an operational processing speed.

According to a first aspect of the invention, there is provided a control signal generation apparatus for receiving (n+1)-bit channel words and selecting an (n+1)-bit channel word which is supplied to a recording unit, for use in a system having means for affixing a one-bit digital word to each n-bit information word in a digital information signal thereby to generate (n+1)-bit information words, precoders for coding successive (n+1)-bit information words into (n+1)-bit channel words, recording means for recording (n+1)-bit channel words supplied from the precoders on an information track in a magnetic record medium, and select means for selectively supplying one of the (n+1)-bit channel words from the precoders to the recording means in response to a control signal (CS), the control signal generation apparatus comprising: first spectrum detection means for detecting peak, notch and dip components at a predetermined frequency from "0"-affixed (n+1)-bit channel words; and second spectrum detection means for detecting peak, notch and dip components at said predetermined frequency from "1"-affixed (n+1)-bit channel words; characterized by further comprising: first comparator means for comparing the peak spectrum components detected in said first and second spectrum detection means and indicating the smaller one; second comparator means for comparing the notch spectrum components detected in said first and second spectrum detection means and indicating the smaller one; third comparator means for comparing the dip spectrum components detected in said first and second spectrum detection means and indicating -the smaller one; and means for determining from the output of the comparator means which of said first and second spectrum detection means outputs more smaller spectrum components, and for generating the control signal (CS) indicating the decision result.

The apparatus preferably further comprises gain control means which compares the peak, notch and dip components of said first and second spectrum detection means with upper limit and lower limit reference set values, and generates a gain control signal according to the comparison results.

Preferably, each of said first and second spectrum detection means comprises a plurality of integrators used for generating peak, notch and dip components, in which an individual integrator controls the gain of an input signal according to the gain control signal of the gain control means.

The gain control signal is preferably used for controlling the gains of the integrators in the first and second spectrum detection means.

Said gain control means preferably generates the gain control signal to increase the gains when all the peak, notch, and dip components are smaller than the lower limit reference set value, while to decrease the gains when at least one of the peak, notch, and dip components is larger than the upper limit reference set value.

Respective integrators preferably control input signals to have the same gain with each other in accordance with the gain control signal.

Each integrator contained in one of said first and second spectrum detection means preferably comprises:
a latch for storing an input signal;
a first amplifier for amplifying an output signal from said latch by two times;
a second amplifier for amplifying the output signal from said latch by one-half times;
a multiplexer for selecting and outputting a one among an integrated value of a corresponding integrator which is contained in the other of first and second spectrum detection means, and output signal of said latch, and output signals of said first and second amplifiers, according to the control signal and gain control signal; and
an adder for adding the output signal of said multiplexer and a channel word to which 1-bit digital word is affixed.

The apparatus may further comprise:
a first gain controller for comparing the peak components of said first and second spectrum detection means with predetermined upper limit and lower limit reference set values, respectively, and for generating a gain control signal according to the comparison result;
a second gain controller for comparing the notch components of said first and second spectrum detection means with the upper limit and lower limit reference set values, respectively, and for generating a gain control signal according to the comparison result; and
a third gain controller for comparing the dip components of said first and second spectrum detection means with predetermined upper limit and lower limit reference set values, respectively, and for generating a gain control signal according to the comparison result,
wherein each of said first and second spectrum detection means comprises a plurality of integrators used for generating peak, notch and dip components, in which an individual integrator controls the gain of an input signal according to corresponding gain control signal.

Each of said first through third gain controllers preferably generates the gain control signal to increase the gains when all the components are smaller than the lower limit reference set value, while to decrease the gains when at least one of the components is larger than the upper limit reference set value.

For a better understanding of the invention, and to show how embodiments of the same may be carried into effect, reference will now be made, by way of example, to the accompanying diagrammatic drawings, in which:
Figure 1 is a block diagram of a conventional apparatus for recording a digital information signal on a record carrier;
Figure 2 is a detailed block diagram of the control signal generator 300 of Figure 1;
Figure 3 is a block diagram of a control signal generation apparatus according to one embodiment of the present invention;
Figure 4 is a detailed circuit diagram of the decision unit 390 of Figure 3;
Figure 5 is a detailed circuit diagram of the automatic gain controller 400 of Figure 3;
Figure 6 is a flowchart diagram showing a gain control signal generation procedure in the controller 420 of Figure 5;
Figure 7 is a detailed circuit diagram of the integrator 315, 355, 325, 365, 335 or 375 of Figure 5;
Figure 8 is a detailed circuit diagram of the multiplexer 430 of Figure 7;
Figure 9 is a block diagram of a control signal generation apparatus according to another embodiment of the present invention; and
Figure 10 is a detailed circuit diagram of the automatic gain controller 401, 402 or 403 of Figure 9.

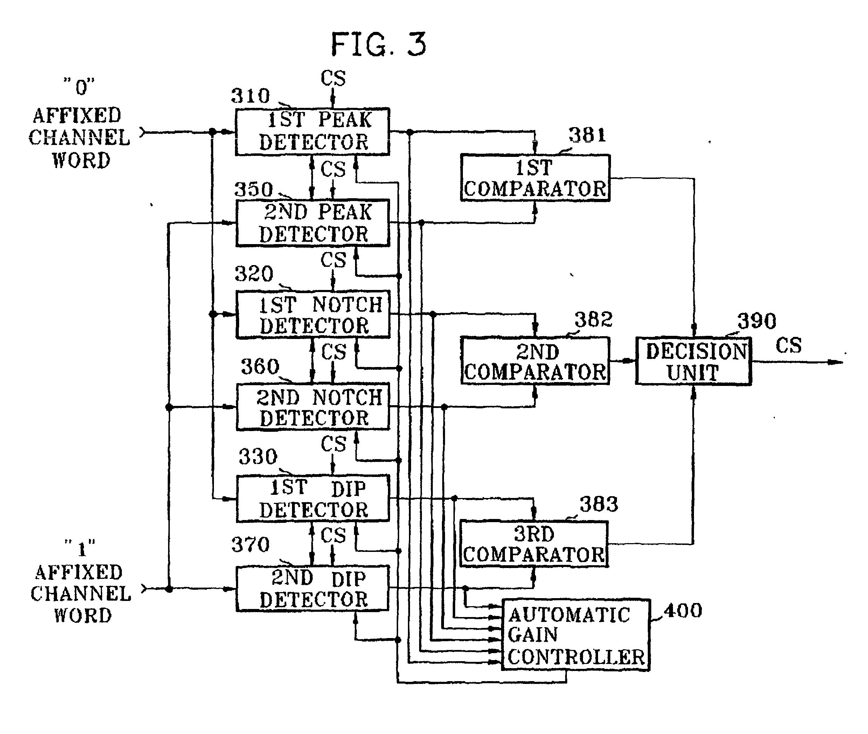

Preferred embodiments of the present invention will be described below in more detail with reference to Figures 3 and 10.

In Figure 3 showing a control signal generation apparatus according to one embodiment of the present invention, a first peak detector 310, a first notch detector 320 and a first dip detector 330 receive a "0"-affixed channel word, respectively. A second peak detector 350, a second notch detector 360 and a second dip detector 370 receive a "1"-affixed channel word, respectively. A first comparator 381 is connected to the outputs of the first peak detector 310 and the second peak detector 350. A second comparator 382 is connected to the outputs of the first notch detector 320 and the second notch detector 360. A third comparator 383 is connected to the outputs of the first dip detector 330 and the second dip detector 370. A decision unit 390 is connected to the outputs of the first through third comparators 381-383. The decision unit 390 generates a control signal CS. The above spectrum component detectors 310 and 350, 320 and 360, and 330 and 370 for detecting the identical spectrum components receive a signal from the mutually corresponding spectrum component detector, respectively. Also, an automatic gain controller (AGC) 400 is connected to the outputs of the spectrum component detectors 310, 320, 330, 350, 360 and 370. The AGC 400 supplies gain control signals GU and GD which will be described later in detail, to the spectrum component detectors 310, 320, 330, 350, 360 and 370.

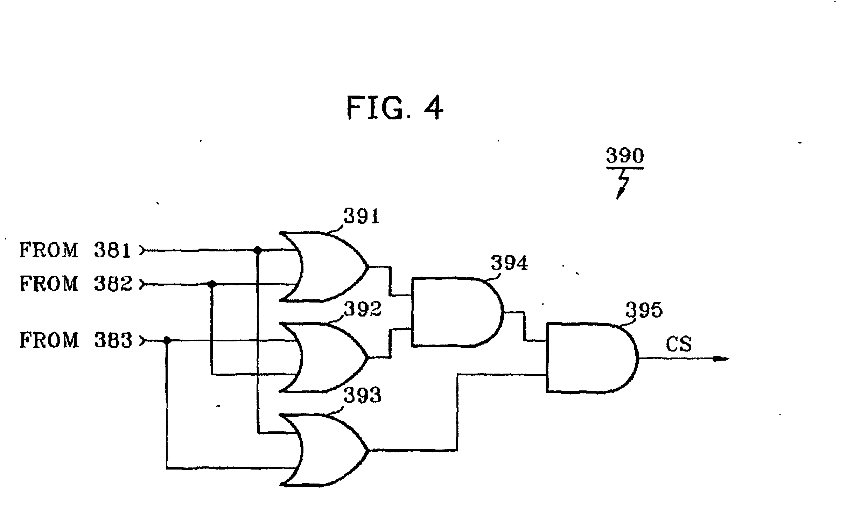

The operation of the Figure 3 apparatus will be described below referring to Figures 4 through 8 showing the detailed blocks of the control signal generation apparatus.

The first peak detector 310, the first notch detector 320 and the first dip detector 330 detect a peak component, a notch component and a dip component from the received "0"-affixed channel word, respectively. The second peak detector 350, the second notch detector 360 and the second dip detector 370 detect the peak, notch and dip components from the received "1"-affixed channel word, respectively. The first through third comparators 381-383 which are connected to the output ends of the spectrum component detectors compare the signals output from the identical spectrum component detectors. That is, the first comparator 381 compares the output signals of the first and second peak detectors 310 and 350 with each other and selects and outputs the smaller one. The second and third comparators 382 and 383 select and output the smaller one with respect to the notch and dip components, respectively, in the same manner as that of the first comparator 381. The decision unit 390 generates a control signal CS which is determined toward the two or more identical results among the output signals of the first through third comparators 381-383.

Figure 4 is a detailed circuit diagram of the decision unit 390 of Figure 3. First through third OR gates 391-393 logically sum two of the output signals of the first through third comparators 381-383, respectively. A first AND gate 394 logically multiplies two (the outputs of the first and second OR gates in Figure 4) of the output signals of the first through third OR gates 391-393. Then, a second AND gate 395 logically multiplies the output signal of the first AND gate 394 by the remaining one (the output of the third OR gate in Figure 4) which is not input to the first AND gate 394 among the output signals of the first through third OR gates 391-393. As a result, the decision unit 390 outputs a control signal CS so that a more often selected signal among the output signals of the comparators 381-383 is determined.

In the prior art Figure 2 apparatus, the first adder 340 having the five inputs is constituted in such a manner that two of the five inputs are added first, and then the result of the first addition is added to one of the remaining three inputs. Accordingly, the first adder 340 can be composed of four adders each having two inputs. Thus, the prior art apparatus totally should include eight adders. Meanwhile the apparatus of Figure 3 changes the adder 340 into three comparators 381-383. Since a comparator circuit is simpler than an adder circuit, the present invention reduces the amount of the hardware circuitry, and outputs the identical result to that of the case when the signals are added and then compared.

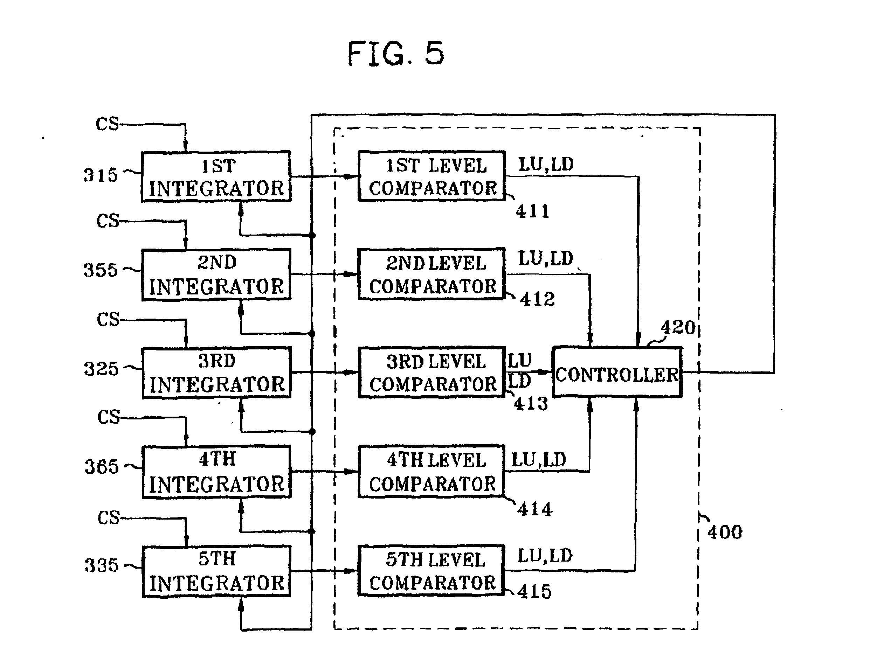

Figure 5 is a detailed circuit diagram of the automatic gain controller 400 of Figure 3. First through fifth level comparators 411-415 in the automatic gain controller 400 receive the output signals of the first through fifth integrators 315, 355, 325, 365 and 335, and compare the received signals with the upper limit and lower limit reference set values T_{high} and T_{low}, respectively. Accordingly, the first through fifth level comparators 411-415 generate level control signals LU and LD for levelling up and down, respectively. A controller 420 receives the level control signals LU and LD from the first through fifth level comparators 411-415, and generates gain control signals GU and GD for increasing and decreasing the gain, respectively. Then, the gain control signals GU and GD are supplied to the first through fifth integrators 315, 355, 325, 365 and 335, respectively. Here the first through fifth integrators correspond to the first and second peak, notch and dip detectors, respectively.

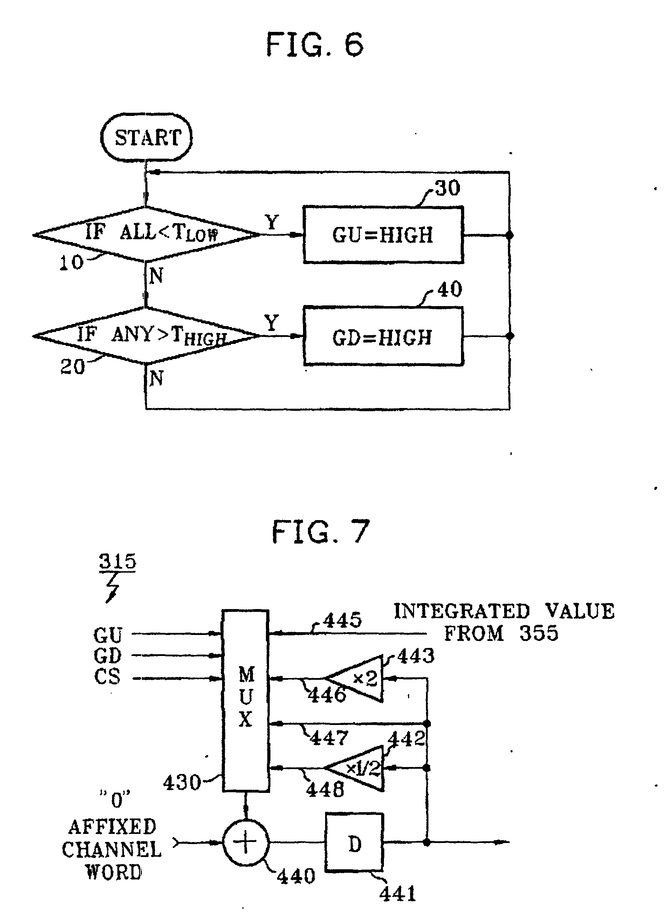

Figure 6 is a flowchart diagram showing the process of generating gain control signals GU and GD in the controller 420 of. Figure 5. When the level up signals LUs of the first through fifth level comparators 411-415 are all high level, that is, the output signals of the first through fifth level comparators 411-415 are smaller than the lower limit reference set value T_{low} in step 10, the controller 420 outputs a high-level gain-up signal GU for increasing the gain in step 20. Then, when there is one or more high-level signals among the level-down signals LUs, a signal which is larger than the upper limit reference set value T_{high} exists in the output signals of the integrators (step 20). In this case, the gain-down signal (GD) is made a high-level signal to decrease the gain in step 40.

Figure 7 is a detailed circuit diagram of the integrator 315 for performing a gain control function of Figure 5. In Figure 7, an adder 440 adds the "0"- or "1"- affixed channel word and the output signal of a multiplexer 430. A D-flip-flop 441 delays the output signal of a second adder 440 by a predetermined time. A first amplifier 442 amplifies the output signal of the D-flip-flop 441 by one-half times. A second amplifier 443 amplifies the output signal of the D-flip-flop 441 by two times.

The multiplexer 430 receives the gain control signal GU and GD of the controller 420 in Figure 5 and the control signal CS of Figure 4, and selects one among the half-times 448, one-time 447 and two-times 446 of the integrated value stored in D-flip-flop 441 and the integrated value 445 of corresponding spectrum component detector 355. Then, the multiplexer 430 negatively feeds back the selected one to the second adder 440.

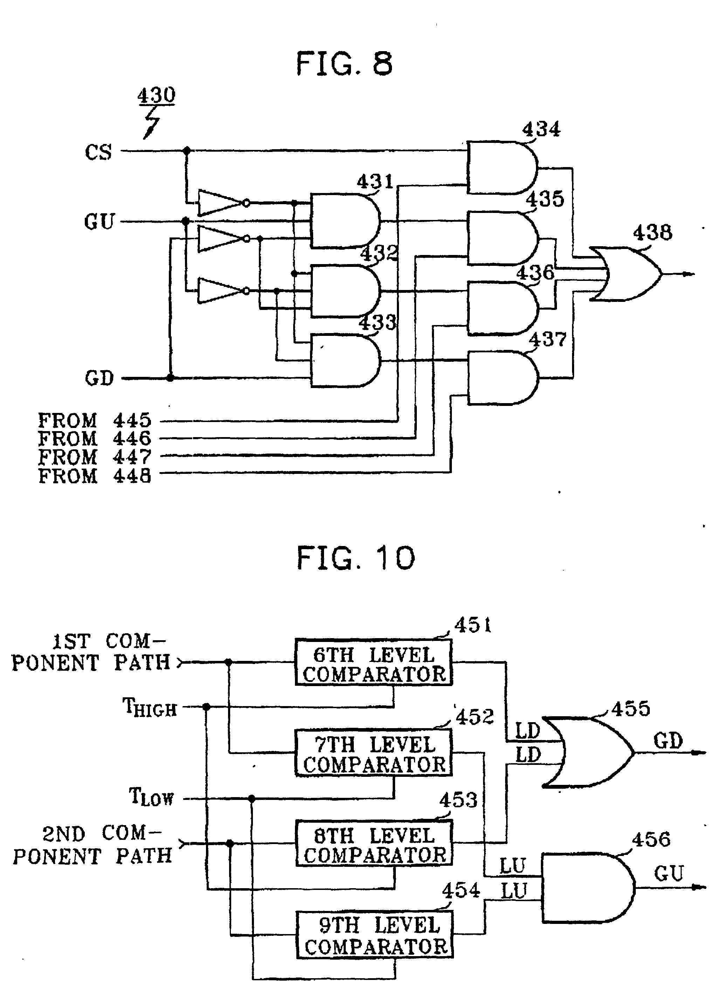

Figure 8 is a detailed circuit diagram of the multiplexer 430 of Figure 7. In Figure 8, a third AND gate 431 logically multiplies a low-level control signal CS, a high-level gain-up signal GU and a low-level gain-down signal GD. A fourth AND gate 432 logically multiplies a low-level control signal CS, a low-level gain-up signal GU and a low-level gain-down signal GD. A fifth AND gate 433 logically multiplies a low-level control signal CS, a low-level gain-up signal GU, and a high-level gain down signal GD. A sixth AND gate 434 logically multiplies a high-level control signal CS and the integration value 445 of the detector 355. A seventh AND gate 435 logically multiplies the output signal of a third AND gate 431 and the integration value 446 being two times the integration value of D-flip-flop 441. An eighth AND gate 436 logically multiplies the output signal of the fourth AND gate 432 and the integration value 447 of D-flip-flop 441. A ninth AND gate 437 logically multiplies the output signal of the fifth AND gate 433 and the integration value 448 being one-half times the integration value of D-flip-flop 441. A fourth OR gate 438 logically sums the output signals of the sixth through ninth AND gates 434-437. The fourth OR gate 438 in Figure 8 outputs the integration value 445 of the relative detector 355 when the control signal CS via the sixth AND gate 434 is high level. Also, if the gain-up signal GU is high level when the control signal CS is low level, the value 446 being two times the integration value of D-flip-flop 441 is selected to thereby increase the gain. Meanwhile, if the gain-down signal GD is high level, the value 448 being one-half times the integration value of D-flip-flop 441 is selected to thereby decrease the gain. Then, if the gain-up and gain-down signals GU and GD are both low level, the integration value 447 of D-flip-flop 441 is output. The signal selected in the fourth OR gate 438 is applied to the second adder 440 of Figure 7, and is added to the "0"- or "1"-affixed signal therein.

By experiment, the integrators of Figure 2 should be constituted with an internal adder circuit having the minimum 16 bits. However, the present invention uses the gain controller, to thereby reduce the number of the maximum allowable bits in the integrator down to 12 bits or less. Particularly, the number of the maximum allowable bits of the integrators in the peak and notch detectors can be reduced down to 10 bits. Also, the comparators can be constituted so that only some of the upper bits of the input signal are used.

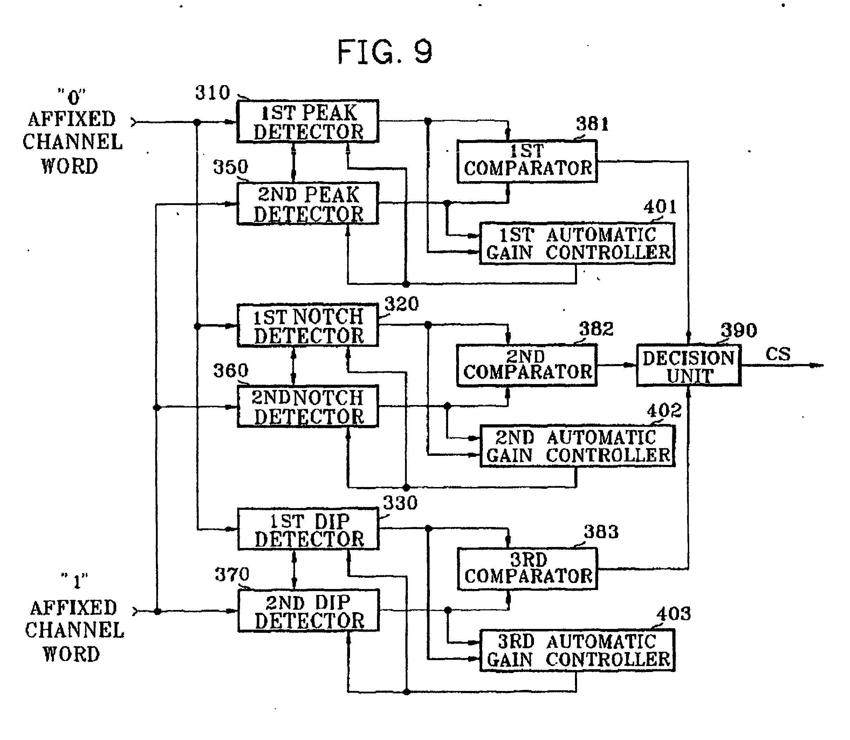

The present invention can independently constitute the gain relationship with respect to the identical spectrum component detection paths. Such an example is shown in Figures 9 and 10.

Figure 9 is a block diagram of a control signal generation apparatus according to another embodiment of the present invention. In Figure 9, a first automatic gain controller 401 is connected to the outputs of a first peak detector 310 and a second peak detector 350. Likewise, a second automatic gain controller 402 is connected to the outputs of a first notch detector 320 and a second notch detector 360. Likewise, a third automatic gain controller 403 is connected to the outputs of a first dip detector 330 and a second dip detector 370. Since the other elements of Figure 9 are the same as those of Figure 3, the detailed description thereof will be omitted.

Figure 10 is a detailed circuit diagram of the first, second or third automatic gain controller 401, 402 or 403 of Figure 9. In Figure 10, a sixth level comparator 451 compares the output signal of the first component such as a peak, notch or dip component, with an upper limit reference set value T_{high}. A seventh level comparator 452 compares the output signal of the first component, with a lower limit reference set value T_{low}. An eighth level comparator 453 compares the output signal of the second component, with an upper limit reference set value T_{high}. A ninth level comparator 454 compares the output signal of the second component, with a lower limit reference set value T_{low}. An OR gate 455 logically sums the output signals of the sixth and eighth level comparators 451 and 453. An AND gate 456 logically multiplies the output signals of the seventh and ninth level comparators 452 and 454.

The sixth and eight level comparators 451 and 453 compare the input signals with the upper limit reference set value T_{high}, respectively. Then, the sixth and eighth level comparators 451 and 453 output the comparison results as a level-down signal LD, respectively. The OR gate 455 generates a gain-down signal GD according to the level-down signal LD. The seventh and ninth level comparators 452 and 454 compare the input signals with the lower limit reference set value T_{low}, respectively. Then, the seventh and ninth level comparators 452 and 454 output the comparison results as a level-up signal LU, respectively. The AND gate 456 generates a gain-up signal GU according to the level-up signal LU.

As described above, the control signal generation apparatus for the digital information signal recording system according to embodiments of the present invention, compares the same kind of components with each other from the "0"- or "1"-affixed signal, selects one of them, and improves a decision unit so that the more frequently selected signal should be selected, to thereby reduce an amount of circuit hardware. Also, embodiments of the present invention use an automatic gain controller to reduce the number of the maximum allowable bits. Accordingly, embodiments of the present invention can increase an operational processing speed of an integrator.

While only certain embodiments of the invention have been specifically described herein, it will be apparent that numerous modifications may be made thereto without departing from the scope of the invention.

## Claims

1. A control signal generation apparatus for receiving (n+1)-bit channel words and selecting an (n+1)-bit channel word which is supplied to a recording unit, for use in a system having means (100, 150) for affixing a one-bit digital word to each n-bit information word in a digital information signal thereby to generate (n+1)-bit information words, precoders (200, 250) for coding successive (n+1)-bit information words into (n+1)-bit channel words, recording means (700) for recording (n+1)-bit channel words supplied from the precoders (200, 250) on an information track in a magnetic record medium, and select means (600) for selectively supplying one of the (n+1)-bit channel words from the precoders (200, 250) to the recording means (700) in response to a control signal (CS), the control signal generation apparatus comprising:
first spectrum detection means (310, 320, 330) for detecting peak, notch and dip components at a predetermined frequency from "0"-affixed (n+1)-bit channel words; and
second spectrum detection means (350, 360, 370) for detecting peak, notch and dip components at said predetermined frequency from "1"-affixed (n+1)-bit channel words;
**characterized by** further comprising:
first comparator means (381) for comparing the peak spectrum components detected in said first and second spectrum detection means (310; 350) and indicating the smaller one;
second comparator means (382) for comparing the notch spectrum components detected in said first and second spectrum detection means (320; 360) and indicating the smaller one;
third comparator means (383) for comparing the dip spectrum components detected in said first and second spectrum detection means (330; 360) and indicating the smaller one; and
means (390) for determining from the output of the comparator means (381-383) which of said first and second spectrum detection means (310, 320, 330; 350, 360, 370) outputs more smaller spectrum components, and for generating the control signal (CS) indicating the decision result.

2. The control signal generation apparatus according to claim 1 further comprising gain control means (400) which compares the peak, notch and dip components of said first and second spectrum detection means (310, 320, 330; 350, 360, 370) with upper limit and lower limit reference set values, and generates a gain control signal according to the comparison results.

3. Apparatus according to claim 2, wherein each of said first and second spectrum detection means (310, 320, 330; 350, 360, 370) comprises a plurality of integrators (315, 355, 325, 365, 335) used for generating peak, notch and dip components, in which an individual integrator controls the gain of an input signal according to the gain control signal of the gain control means (400).

4. Apparatus according to claim 3, wherein the gain control signal is used for controlling the gains of the integrator in the first and second spectrum detection means.

5. The control signal generating apparatus according to claim 2, 3 or 4, wherein said gain control means (400) generates the gain control signal to increase the gains when all the peak, notch, and dip components are smaller than the lower limit reference set value, while to decrease the gains when at least one of the peak, notch, and dip components is larger than the upper limit reference set value.

6. The control signal generation apparatus according to claim 5, wherein respective integrators (315, 355, 325, 365, 335) control input signals to have the same gain with each other in accordance with the gain control signal.

7. The control signal generation apparatus according to claim 6, wherein each integrator contained in one of said first and second spectrum detection means (310, 320, 330; 350, 360, 370) comprises:
a latch (441) for storing an input signal;
a first amplifier (443) for amplifying an output signal from said latch (441) by two times;
a second amplifier (442) for amplifying the output signal from said latch (441) by one-half times;
a multiplexer (430) for selecting and outputting a one among an integrated value of a corresponding integrator (315, 355, 325, 365, 335) which is contained in the other of first and second spectrum detection means, and output signal of said latch (441), and output signals of said first and second amplifiers (442, 443), according to the control signal (CS) and gain control signal; and
an adder (440) for adding the output signal of said multiplexer and a channel word to which 1-bit digital word is affixed.

8. The control signal generation apparatus according to claim 1, the apparatus further comprising:
a first gain controller (401) for comparing the peak components of said first and second spectrum detection means (310, 350) with predetermined upper limit and lower limit reference set values, respectively, and for generating a gain control signal according to the comparison result;
a second gain controller (402) for comparing the notch components of said first and second spectrum detection means (320, 360) with the upper limit and lower limit reference set values, respectively, and for generating a gain control signal according to the comparison result; and
a third gain controller (403) for comparing the dip components of said first and second spectrum detection means (330, 370) with predetermined upper limit and lower limit reference set values, respectively, and for generating a gain control signal according to the comparison result,
wherein each of said first and second spectrum detection means (310, 320, 330; 350, 360, 370) comprises a plurality of integrators (315, 355, 325, 365, 335) used for generating peak, notch and dip components, in which an individual integrator controls the gain of an input signal according to corresponding gain control signal.

9. The control signal generation apparatus according to claim 8, wherein each of said first through third gain controller (401 - 403) generates the gain control signal to increase the gains when all the components are smaller than the lower limit reference set value, while to decrease the gains when at least one of the components is larger than the upper limit reference set value.

## Patentansprüche

1. Vorrichtung zur Steuersignalerzeugung, die zum Empfang von (n+1)-Bit-Kanalwörtern und zur Auswahl eines (n+1)-Bit-Kanalwortes, welches einer Aufnahmeeinrichtung zugeführt wird, zum Gebrauch in einem System, das
eine Einrichtung (100, 150), die ein Ein-Bit-Digitalwort an jedes n-Bit-Informationswort in einem digitalen Informationssignal zur Erzeugung von (n+1)-Bit-Informationswörtern hinzufügt,
einen Vorcodierer (200, 250) zum Codieren aufeinanderfolgender (n+1)-Bit-Informationswörtern in (n+1)-Bit-Kanalwörter,
eine Aufnahmeeinrichtung (700) zum Aufnehmen von (n+1)-Bit-Kanalwörtern, welche von den Vorcodierern (200, 250) auf einer Informationsspur in einem magnetischen Aufnahmemedium zugeführt werden, und
eine Selektionseinrichtung (600) zum selektiven Zuführen eines der (n+1)-Bit-Kanalwörter von den Vorcodierern (200, 250) an die Aufnahmeeinrichtung (700) abhängig von einem Steuersignal (CS) aufweist, wobei die Vorrichtung zur Steuersignalerzeugung aufweist:
eine erste Spektrum-Detektionseinrichtung (310, 320, 330) zum Detektieren eines Spektrums, die Spitzen-, Einschnitt-bzw. Minimal- und Einsattelungskomponenten bzw. -signalanteile bei einer vorbestimmten Frequenz von "0"-zugeordneten (n+1)-Bit-Kanalwörtern delektiert; und
eine zweite Spektrum-Detektionseinrichtung (350, 360, 370) zum Detektieren eines Spektrums, die Spitzen-, Einschnitt-bzw. Minimal- und Einsattelungskomponenten bzw. -signalanteile bei dieser vorbestimmten Frequenz von "1"-zugeordneten (n+1)-Bit-Kanalwörtern detektiert;
**dadurch gekennzeichnet, dass** die Vorrichtung ferner aufweist:
eine erste Vergleichseinrichtung (381) zum Vergleichen der Spitzenanteile des Spektrums, die von der ersten und zweiten Spektrum-Detektionseinrichtung (310, 350) detektiert wurden, und zum Anzeigen des kleineren davon;
eine zweite Vergleichseinrichtung (382) zum Vergleichen der Einschnitt- bzw. Minimalanteile des Spektrums, die von der ersten und zweiten Spektrum-Detektionseinrichtung (320, 360) detektiert wurden, und zum Anzeigen des kleineren davon; und
eine dritte Vergleichseinrichtung (383) zum Vergleichen der Einsattelungsanteile des Spektrums, die von der ersten und zweiten Spektrum-Detektionseinrichtung (330, 370) detektiert wurden, und zum Anzeigen des kleineren davon; und
eine Einrichtung (390), die aus dem Ausgangssignal der Vergleichseinrichtungen (381-383) bestimmt, welche der Spektrum-Detektionseinrichtungen (310, 320, 330; 350, 360, 370) kleinere Anteile des Spektrums ausgeben, und das Steuersignal (CS) erzeugt, welches das Entscheidungsergebnis anzeigt.

2. Vorrichtung zur Erzeugung eines Steuersignals gemäß Anspruch 1, die ferner aufweist: eine Verstärkungssteuereinrichtung (400) zum Steuern einer Verstärkung, wobei die Verstärkungssteuereinrichtung (400) die Spitzen-, Einschnitts- und Einsattelungsanteile der Spektrum-Detektionseinrichtungen (310, 320, 330; 350, 360, 370) mit oberen Grenzwert und unteren Grenzwert-Referenz-Sollwerten vergleicht und entsprechend den Vergleichsergebnissen ein Verstärkungssteuersignal erzeugt.

3. Vorrichtung nach Anspruch 2, bei der jede der Spektrum-Detektionseinrichtungen (310, 320, 330; 350, 360, 370) eine Vielzahl von Integratoren (315, 355, 325, 365, 335) aufweist, die zur Erzeugung von Spitzen-, Einschnitts- und Einsattelungskomponenten genutzt werden, in welchen ein einzelner Integrator die Verstärkung eines Eingangssignals entsprechend dem von der Verstärkungssteuereinrichtung (400) abgegebenen Verstärkungssteuersignal steuert.

4. Vorrichtung nach Anspruch 3, in welchem das Verstärkungssteuersignal zum Steuern der Verstärkungen des Integrators in der ersten und zweiten Spektrum-Detektiereinrichtung genutzt wird.

5. Vorrichtung zur Erzeugung eines Steuersignals gemäß den Ansprüchen 2, 3 oder 4, bei der die Verstärkungssteuereinrichtung (400) das Verstärkungssteuersignal erzeugt, um die Verstärkungen zu vergrößern, wenn alle Spitzen-, Einschnitt- und Einsattelungskomponenten kleiner sind als der als untere Grenze gesetzte Referenz-Sollwert, während die Verstärkungen erniedrigt werden, wenn wenigstens eines der Spitzen-, Einschnitts- und Einsattelungskomponenten größer ist als der als obere Grenze gesetzte Referenz-Sollwert.

6. Vorrichtung zum Erzeugen eines Steuersignals nach Anspruch 5, bei der die jeweiligen Integratoren (315, 355, 325, 365, 335) die Eingangssignale steuern, um untereinander die gleiche Verstärkung entsprechend dem Verstärkungssteuersignal zu haben.

7. Vorrichtung zur Erzeugung eines Steuersignals nach Anspruch 6, bei der jeder Integrator, der in einer der Spektrum-Detektionseinrichtungen (310, 320, 330; 350, 360, 370) enthalten ist, aufweist:
eine Latch-Schaltung (441) zum Speichern eines Eingangssignals;
einen ersten Verstärker (443) zum zweifachen Verstärken eines Ausgangssignals der Latch-Schaltung (441);
einen zweiten Verstärker (442) zum 1,5-fachen Verstärken des Ausgangssignals der Latch-Schaltung (441);
einen Multiplexer (430) zum Auswählen und zum Ausgeben einer Eins unter einem integrierten Wert eines korrespondierenden Integrators (315, 355, 325, 365, 335), der in der anderen Spektrum-Detektionseinrichtung enthalten ist, und eines Ausgangssignals der Latch-Schaltung (441), und von Ausgangssignalen der ersten und zweiten Verstärker (442, 443) entsprechend dem Steuersignal (CS) und dem Verstärkungssteuersignal; und
einen Addierer (440) zum Addieren des Ausgangssignals des Multiplexers (430) und eines Kanalwortes, an welchem ein 1-Bit-Digitalwort hinzugefügt ist.

8. Vorrichtung zur Erzeugung eines Steuersignals nach Anspruch 1, wobei die Vorrichtung ferner aufweist:
eine erste Verstärkungssteuereinheit (401) zum Vergleichen der Spitzenkomponenten der Spektrum-Detektionseinrichtungen (310, 350) mit den vorbestimmten, jeweiligen oberen und unteren Grenz-Referenz-Sollwerten und zum Erzeugen eines Verstärkungssteuersignals entsprechend dem Vergleichsergebnis;
eine zweite Verstärkungssteuereinheit (402) zum Vergleichen der Einschnittskomponenten der Spektrum-Detektionseinrichtungen (320, 360) mit den jeweiligen oberen und unteren Grenz-Referenz-Sollwerten und zum Erzeugen eines Verstärkungssteuersignals entsprechend dem Vergleichsergebnis, und
eine dritte Verstärkungssteuereinheit (403) zum Vergleichen der Einsattelungskomponenten der Spektrum-Detektionseinrichtungen (330, 370) mit den jeweiligen vorbestimmten oberen und unteren Grenz-Referenz-Sollwerten gesetzten Referenzwerte und zum Erzeugen eines Verstärkungssteuersignals entsprechend dem Vergleichsergebnis,
wobei jede der beiden Spektrum-Detektionseinrichtungen (310, 320, 330; 350, 360, 370) eine Vielzahl von Integratoren (315, 355, 325, 365, 335) aufweist, die zum Erzeugen der Spitzen-, Einschnitts- und Einsattelungskomponenten vorgesehen sind, wobei ein einzelner Integrator die Verstärkung eines Eingangssignals entsprechend dem korrespondierenden Verstärkungssteuersignal steuert.

9. Vorrichtung zum Erzeugen eines Steuersignals nach Anspruch 8, bei der jede der ersten bis dritten Verstärkungssteuereinheiten (401-403) das Verstärkungssteuersignal zur Erhöhung der Verstärkungen, wenn alle Komponenten kleiner als der untere Grenz-Referenz-Sollwert sind, und zur Herabsetzung der Verstärkungen erzeugt, wenn wenigstens eine der Komponenten größer als der obere Grenz-Referenz-Sollwert ist.

## Revendications

1. Dispositif de génération de signaux de commande pour recevoir des mots de canal à (n+1) bits et sélectionner un mot de canal à (n+1) bits qui est délivré à une unité d'enregistrement, destiné à être utilisé dans un système ayant des moyens (100, 150) pour affixer un mot numérique à un bit à chaque mot d'informations à n bits se trouvant dans un signal d'informations numérique de manière à générer des mots d'informations à (n+1) bits, des précodeurs (200, 250) pour coder des mots d'informations à (n+1) bits successifs sous forme de mots de canal à (n+1) bits, des moyens d'enregistrement (700) pour enregistrer des mots de canal à (n+1) bits délivrés par les précodeurs (200, 250) sur une piste d'informations d'un support d'enregistrement magnétique, et des moyens de sélection (600) pour délivrer sélectivement l'un des mots de canal à (n+1) bits à partir des précodeurs (200, 250) aux moyens d'enregistrement (700) en réponse à un signal de commande (CS), le dispositif de génération de signaux de commande comportant :
des premiers moyens de détection de spectre (310, 320, 330) pour détecter des composants de crête, d'encoche et d'inclinaison à une fréquence prédéterminée à partir de mots de canal à (n+1) bits affixés de "0", et
des seconds moyens de détection de spectre (350, 360, 370) pour détecter des composants de crête, d'encoche et d'inclinaison à ladite fréquence prédéterminée à partir de mots de canal à (n+1) bits affixés de "1",
**caractérisé en ce qu'**il comporte en outre :
des premiers moyens comparateurs (381) pour comparer les composants spectraux de crête détectés dans lesdits premiers et seconds moyens de détection de spectre (310 ; 350) et indiquant le plus petit d'entre eux,
des deuxièmes moyens comparateurs (382) pour comparer les composants spectraux d'encoche détectés dans lesdits premiers et seconds moyens de détection de spectre (320 ; 360) et indiquant le plus petit d'entre eux,
des troisièmes moyens comparateurs (383) pour comparer les composants spectraux d'inclinaison détectés dans lesdits premiers et seconds moyens de détection de spectre (330 ; 360) et indiquant le plus petit d'entre eux, et
des moyens (390) pour déterminer à partir de la sortie des moyens comparateurs (381 à 383) les moyens parmi lesdits premiers et seconds moyens de détection de spectre (310, 320, 330 ; 350, 360, 370) qui délivrent en sortie de plus petits composants spectraux, et pour générer le signal de commande (CS) indiquant le résultat de décision.

2. Dispositif de génération de signaux de commande selon la revendication 1, comportant en outre des moyens de commande de gain (400) qui comparent les composants de crête, d'encoche et d'inclinaison desdits premiers et seconds moyens de détection de spectre (310, 320, 330 ; 350, 360, 370) à des valeurs de consigne de référence de limite supérieure et de limite inférieure, et génèrent un signal de commande de gain en fonction des résultats de comparaison.

3. Dispositif selon la revendication 2, dans lequel chacun desdits premiers et seconds moyens de détection de spectre (310, 320, 330 ; 350, 360, 370) comporte une pluralité d'intégrateurs (315, 355, 325, 365, 335) utilisés pour générer des composants de crête, d'encoche et d'inclinaison, un intégrateur individuel commandant le gain d'un signal d'entrée conformément au signal de commande de gain des moyens de commande de gain (400).

4. Dispositif selon la revendication 3, dans lequel le signal de commande de gain est utilisé pour commander les gains de l'intégrateur dans les premiers et seconds moyens de détection de spectre.

5. Dispositif de génération de signaux de commande selon la revendication 2, 3 ou 4, dans lequel lesdits moyens de commande de gain (400) génèrent le signal de commande de gain pour augmenter les gains lorsque tous les composants de crête, d'encoche, et d'inclinaison sont plus petits que la valeur de consigne de référence de limite inférieure, tandis qu'ils diminuent les gains lorsqu'au moins l'un des composants de crête, d'encoche et d'inclinaison est plus grand que la valeur de consigne de référence de limite supérieure.

6. Dispositif de génération de signaux de commande selon la revendication 5, dans lequel les intégrateurs (315, 355, 325, 365, 335) respectifs commandent les signaux d'entrée de manière à avoir le même gain les uns et les autres conformément au signal de commande de gain.

7. Dispositif de génération de signaux de commande selon la revendication 6, dans lequel chaque intégrateur contenu dans l'un desdits premiers et seconds moyens de détection de spectre (310, 320, 330 ; 350, 360, 370) comporte :
un verrou (441) pour mémoriser un signal d'entrée,
un premier amplificateur (443) pour amplifier un signal de sortie provenant dudit verrou (441) de deux durées,
un second amplificateur (442) pour amplifier le signal de sortie provenant dudit verrou (441) d'une demi-durée,
un multiplexeur (430) pour sélectionner et délivrer en sortie l'un parmi une valeur intégrée d'un intégrateur (315, 355, 325, 365, 335) correspondant qui est contenu dans les autres moyens parmi les premiers et seconds moyens de détection de spectre, et un signal de sortie dudit verrou (441), et des signaux de sortie desdits premier et second amplificateurs (442, 443), conformément au signal de commande (CS) et au signal de commande de gain, et
un additionneur (440) pour additionner le signal de sortie dudit multiplexeur et un mot de canal auquel est affixé un mot numérique à un bit.

8. Dispositif de génération de signaux de commande selon la revendication 1, le dispositif comportant en outre :
un premier contrôleur de gain (401) pour comparer les composants de crête desdits premiers et seconds moyens de détection de spectre (310, 350) à des valeurs de consigne de référence de limite supérieure et de limite inférieure, respectivement, et pour générer un signal de commande de gain en fonction du résultat de comparaison,
un deuxième contrôleur de gain (402) pour comparer les composants d'encoche desdits premiers et seconds moyens de détection de spectre (320, 360) à des valeurs de consigne de référence de limite supérieure et de limite inférieure, respectivement, et pour générer un signal de commande de gain en fonction du résultat de comparaison, et
un troisième contrôleur de gain (403) pour comparer les composants d'inclinaison desdits premiers et seconds moyens de détection de spectre (330, 370) à des valeurs de consigne de référence de limite supérieure et de limite inférieure prédéterminées, respectivement, et pour générer un signal de commande de gain en fonction du résultat de comparaison,
dans lequel chacun desdits premiers et seconds moyens de détection de spectre (310, 320, 330 ; 350, 360, 370) comporte une pluralité d'intégrateurs (315, 355, 325, 365, 335) utilisés pour générer des composants de crête, d'encoche et d'inclinaison, un intégrateur individuel commandant le gain d'un signal d'entrée conformément au signal de commande de gain correspondant.

9. Dispositif de génération de signaux de commande selon la revendication 8, dans lequel chacun desdits premier à troisième contrôleurs de gain (401 à 403) génère le signal de commande de gain pour augmenter les gains lorsque tous les composants sont plus petits que la valeur de consigne de référence de limite inférieure, tandis qu'il diminue les gains lorsqu'au moins l'un des composants est plus grand que la valeur de consigne de référence de limite supérieure.
